# EUROPEAN PATENT APPLICATION

(11) **EP 1 503 412 A2**
(43) Date of publication of application: **02.02.2005**
(21) Application number: 04017875.8
(22) Date of filing: 28.07.2004
(51) Int. Cl.: H01L 23/00, H01L 23/31

(54) **Semiconductor device and manufacturing method of the same**

(30) Priority: 28.07.2003 JP 2003280981
(71) Applicant: Sanyo Electric Co., Ltd., Moriguchi-shi, Osaka 570-8677 (JP)
(72) Inventor: Ikeda, Osamu, Ora-gun, Gunma (JP)
(74) Representative: Glawe, Delfs, Moll & Partner

(57) **Abstract**

The invention provides a semiconductor package and a manufacturing method thereof where reliability improves. The method has preparing a semiconductor wafer (10) having a plurality of devices (30) to be sealed (a semiconductor integrated circuit, a CCD, and so on) and a glass substrate (11) for supporting the semiconductor wafer (10) and sealing the devices (30) to be sealed, coating room temperature curable resin (12) on either a surface of the semiconductor wafer (10) facing to the glass substrate (11) or a surface of the glass substrate (11) facing to the semiconductor wafer (10), attaching the semiconductor wafer (10) and the glass substrate (11) with the room temperature curable resin (12) disposed therebetween at room temperature, and dividing the semiconductor wafer (10) into individual semiconductor packages by cutting it along a scribe line (SL).

## Description

### Field of the Invention

This invention relates to a semiconductor device and a manufacturing method thereof, particularly to a chip size package and a manufacturing method thereof.

### Description of the Related Art

In recent years, a CSP (chip size package) has been receiving attention as a three-dimensional mounting technology and a new packaging technology. The CSP is a small sized package having almost the same dimension as a semiconductor chip.

Conventionally, a CSP of BGA (ball grid array) type has been known as one of the CSP. The CSP of BGA type is such formed that a plurality of ball-shaped conductive terminals is arrayed in a matrix on a surface of the CSP, and the conductive terminals and pad electrodes and so on of a semiconductor integrated circuit to be mounted on another surface of the CSP are electrically connected.

When this CSP is set in an electric device, the conductive terminals are pressed into contact with wiring on a printed board, thereby electrically connecting the semiconductor integrated circuit in the CSP and an external circuit mounted on the printed board.

This CSP of BGA type has advantages of having more conductive terminals and being miniaturized more than a CSP of other type such as a SOP (small outline package) or a QFP (quad flat package) which has protruding lead pins on its sides. Such a CSP can be used as an image sensor chip for a digital camera mounted on a cellular phone, for example. When a light-receiving element such as a CCD (charge coupled device) is used as the image sensor and devices to be sealed, the sealing material is made of a light transmitting material such as glass.

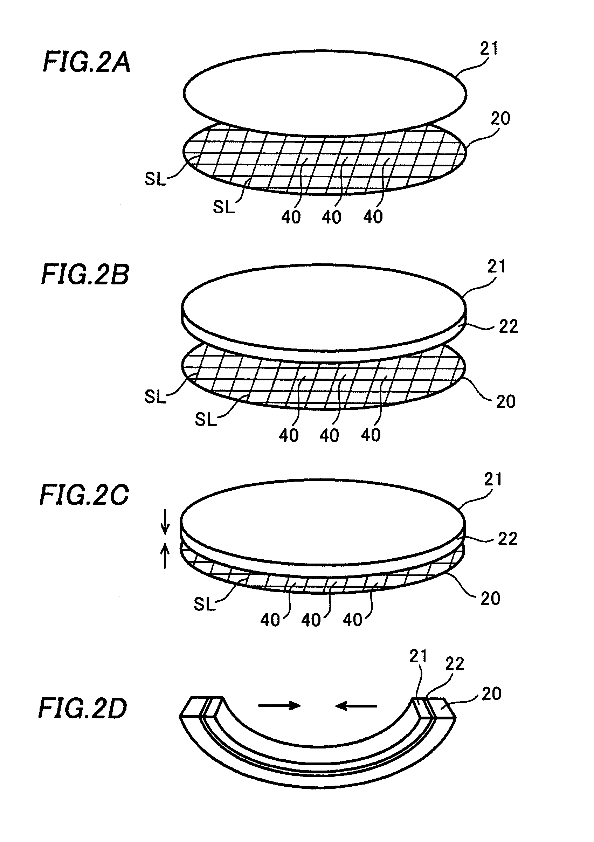

Next, a conventional manufacturing method of the CSP will be described with reference to drawings. Figs. 2A, 2B, 2C and 2D are perspective views showing the conventional manufacturing method of the CSP.

As shown in Fig. 2A, a semiconductor wafer 20 (e.g. made of silicon) and a glass substrate 21 for sealing and supporting the semiconductor wafer 20 are prepared. The semiconductor wafer 20 has a plurality of semiconductor integrated circuit 40, light-receiving elements (not shown) such as CCDs, and so on thereon. The glass substrate 21 has characteristics of transmitting light from outside to the light-receiving elements such as CCDs formed on the semiconductor wafer 20.

As shown in Fig. 2B, high temperature curable resin 22 is coated on either a surface of the semiconductor wafer 20 facing the glass substrate 21 or a surface of the glass substrate 21 facing the semiconductor wafer 20. The high temperature curable resin 22 has a function of curing at high temperature (about 120°C) and attaching elements together coated with this resin.

As shown in Fig. 2C, the glass substrate 21 and the semiconductor wafer 20 are attached with the high temperature curable resin 22 disposed therebetween, and then the high temperature curable resin 22 is cured at high temperature (about 120°C). Attachment between the glass substrate 21 and the semiconductor wafer 20 is thus completed.

Although not shown, the temperature is then lowered from high temperature (120°C) to room temperature (about 25°C), and a plurality of the conductive terminals to be electrically connected with the pad electrodes in the CSPs is formed on a surface of a substrate of the CSPs. Then, the semiconductor wafer 20 attached with the glass substrate 21 is cut along its scribe line SL and divided into individual semiconductor chips, i.e., the CSPs.

However, when the temperature reaches the room temperature after the completion of the attaching the semiconductor wafer 20 to the glass substrate 21 using the high temperature curable resin 22, the glass substrate 21 shrinks more than the semiconductor wafer 20 so that the assembled structure bends with the glass substrate 21 forming an inner beam, as shown in Fig. 2D.

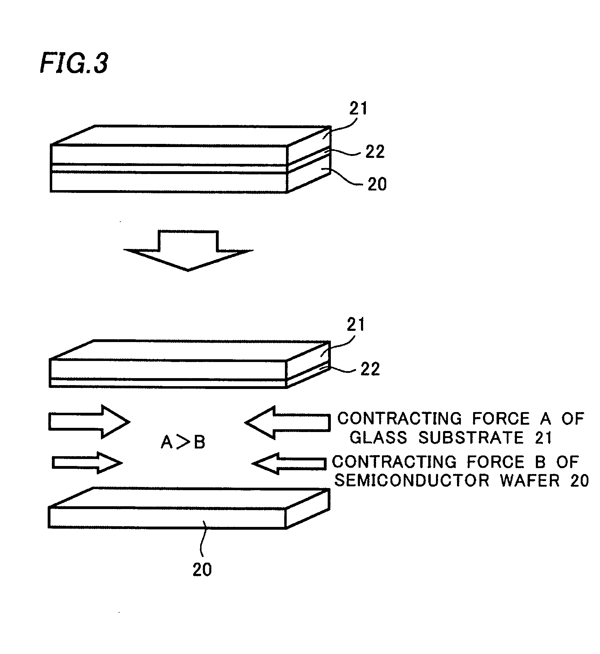

The stress profile generated in the semiconductor wafer 20 and the glass substrate 21 will be described with reference to schematic perspective views of the semiconductor wafer 20 and the glass substrate 21 of Fig. 3.

As shown in Fig. 3, generally, the linear thermal expansion coefficient of the glass substrate 21 is about + 10 PPM/degree. Even a high quality glass, which is expected to have a low linear thermal expansion coefficient for attachment to silicon, has a coefficient of about +4 PPM/degree. This is still higher than the linear thermal expansion coefficient of the semiconductor wafer 20, i.e. 2 PPM/degree. Accordingly, when the high temperature curable resin is cured, high temperature (about 120°C) makes the glass substrate 21 having a higher linear thermal expansion coefficient expand more than the semiconductor wafer 20 having a lower linear thermal expansion coefficient.

Then, when the temperature is lowered to the room temperature, contracting force A of the glass substrate 21 having a higher linear thermal expansion coefficient becomes larger than contracting force B of the semiconductor wafer 20 having a lower linear thermal expansion coefficient. That is, stresses are generated at the boundary between the semiconductor wafer 20 and the glass substrate 21, corresponding to the difference between the contracting force A and B. Accordingly, at room the temperature, the glass substrate 21 shrinks more than the semiconductor wafer 20 attached thereto so that the glass substrate 21 bends inwardly .

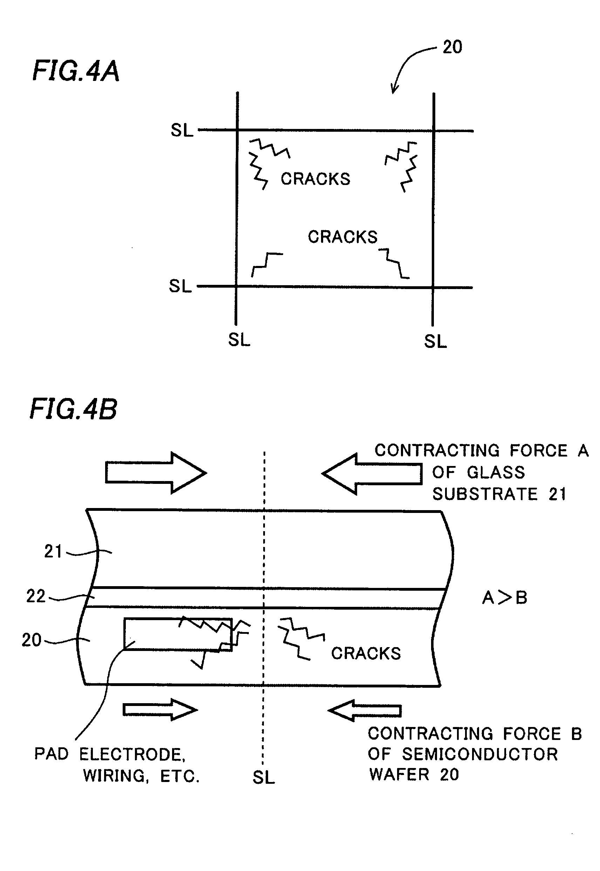

The stresses generated at the boundary between the semiconductor wafer 20 and the glass substrate 21 are released rapidly when the semiconductor wafer 20 is divided into individual packages by cutting. This is shown in Figs. 4A and 4B. Fig. 4A is a plan view of the semiconductor wafer 20 and the glass substrate 21, and Fig. 4B is a cross-sectional view of the semiconductor wafer 20 and the glass substrate 21. As shown in Figs. 4A and 4B, with this rapid release of the stress, cracks occur near a scribe line SL of the semiconductor wafer 20. These cracks cause an operational error, moisture absorption, a wiring error, and so on in the CSP.

Furthermore, even after cutting, the stresses caused by the difference in the contracting force between the semiconductor wafer 20 and the glass substrate 21 still remain in each of the packages. Therefore, an integrated circuit, its pad electrode, an organic film, or microlens formed on the semiconductor substrate are damaged by wearing in a temperature cycle test.

A variety of methods are used for solving the above problems. One method is that the glass substrate 21 is formed of the glass material having a linear thermal expansion coefficient approximately equal to that of the material (e.g. silicon) of the semiconductor wafer 20. This method reduces the difference in contracting force at the boundary between the semiconductor wafer 20 and the glass substrate 21 so that the stress at the boundary reduces.

Another method for solving the above problems is that a blade used for cutting is kept high in quality. This method can reduce cracks when cutting.

However, in the first approach to the problems described above, although the stresses caused by the temperature difference can be reduced, the material of the glass substrate 21 costs higher than the glass material generally used for sealing, thereby causing a problem of increasing a manufacturing cost.

In the second approach to the problems, although cracks caused by releasing the stresses when cutting can be reduced, frequency in blade replacement increases and blades of high quality and tests during a procedure need be provided, thereby increasing the manufacturing cost.

### SUMMARY OF THE INVENTION

It is an object of this invention to provide a semiconductor wafer and a method of manufacturing thereof that lessens these drawbacks.

The solution according to the invention lies in the features of the independent claims and preferably in those of the dependent claims.

The invention provides a semiconductor device including a semiconductor wafer having a plurality of semiconductor integrated circuits, a supporting substrate supporting the semiconductor wafer, and a layer of a room temperature curable resin attaching the semiconductor wafer to the supporting substrate.

The invention also provides a method of manufacturing a semiconductor device. The method includes preparing a semiconductor wafer having a plurality of semiconductor integrated circuits, preparing a supporting substrate, coating a room temperature curable resin on a surface of the semiconductor wafer or a surface of the supporting substrate, attaching at a room temperature the semiconductor wafer to the supporting substrate so that the room temperature curable resin is placed between the semiconductor wafer and the supporting substrate, and dividing the semiconductor wafer attached to the supporting substrate into individual semiconductor chips by cutting the semiconductor wafer along scribe lines thereof.

In the above manufacturing method of the semiconductor device of the invention, the room temperature curable resin is ultraviolet curable resin or two-component epoxy resin.

In the above manufacturing method of the semiconductor device of the invention, the semiconductor wafer and the supporting substrate can be attached at room temperature. This can realize a semiconductor package in which cracks caused by stress caused by a difference in linear thermal expansion coefficient between the semiconductor wafer and the supporting substrate hardly occur.

Furthermore, a special glass material or cutting blade of high quality which has been required conventionally, is not required when realizing the above semiconductor package.

This prevents increasing of a manufacturing cost for realizing such a semiconductor package.

### BRIEF DESCRIPTION OF THE DRAWINGS

Figs. 1A, 1B, 1C and 1D are perspective views showing a semiconductor device and a manufacturing method thereof of an embodiment of the invention.
Figs. 2A, 2B, 2C and 2D are perspective views showing a manufacturing method of a semiconductor device of a conventional art.
Fig. 3 is a perspective view showing part of the semiconductor device of the conventional art.
Figs. 4A and 4B are a plan view and a cross-sectional view respectively, showing part of the semiconductor device of the conventional art.

### DETAILED DESCRIPTION OF THE INVENTION

Next, a semiconductor package and a manufacturing method thereof of an embodiment of the invention will be described with reference to drawings in detail.

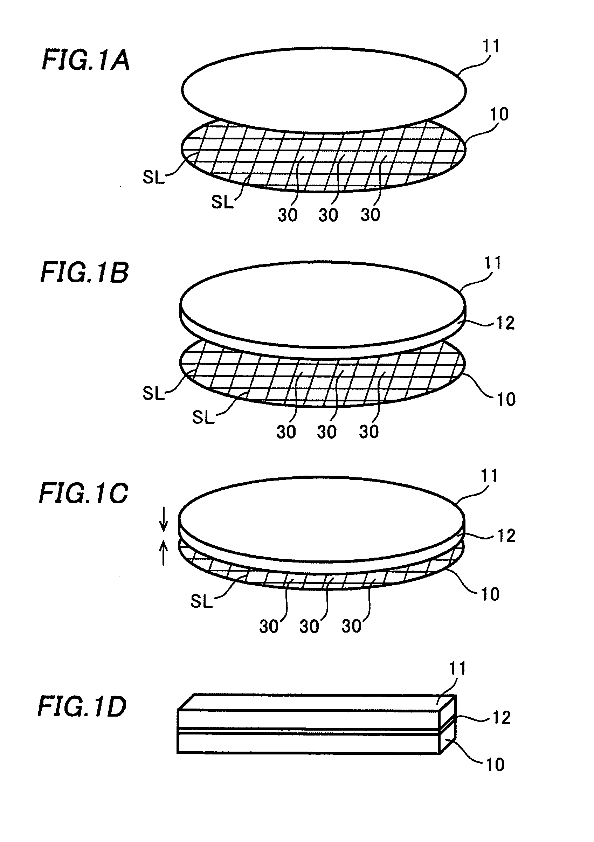

Figs. 1A, 1B, 1C and 1D are perspective views showing a semiconductor package and its manufacturing method of the embodiment of the invention. The manufacturing method of the semiconductor package follows steps described below.

As shown in Fig. 1A, a semiconductor wafer 10 (e.g. made of silicon) having a plurality of devices to be sealed 30, e.g. semiconductor integrated circuit or CCD, is prepared. The devices to be sealed are formed in each of regions divided into a matrix with a scribe line SL on the semiconductor wafer 10.

Then, a glass substrate 11 for supporting the semiconductor wafer 10 and sealing the devices to be sealed is prepared. Although it is preferable that the linear thermal expansion coefficient of this glass substrate 11 is close to the linear thermal expansion coefficient of the semiconductor wafer 10, the embodiment is not limited to this and the semiconductor wafer 10 and the glass substrate 11 can have a different linear thermal expansion coefficient. For example, the linear thermal expansion coefficient of the glass substrate 11 may be 4 PPM/degree and, and that of the semiconductor wafer 10 may be 2 PPM/degree.

As shown in Fig. 1B, a room temperature curable resin 12 is coated on either a surface of the semiconductor wafer 10 facing the glass substrate 11 or a surface of the glass substrate 11 facing the semiconductor wafer 10. In Fig. 1B, the room temperature curable resin 12 is coated on the surface of the glass substrate 11 facing the semiconductor wafer 10.

This room temperature curable resin 12 cures at the room temperature (about 25°C). It is preferable that the room temperature curable resin 12 is an ultraviolet curable resin (e.g. UV curable resin for general use from TESK Co., Ltd: A-1363, A-1368, A-1408, etc), which cures when irradiated with ultraviolet ray. Alternatively, the room temperature curable resin 12 can be two-component epoxy resin (e.g. two-component epoxy resin of low viscosity from TESK Co., Ltd: C-1074A/B, C-1075A/B, etc) or an epoxy resin of other type (e.g. light curing epoxy resin adhesives "PARQIT" from Autex, Inc., etc).

Then, as shown in Fig. 1C, the surface of the glass substrate 11 coated with the room temperature curable resin 12 is closely attached to the surface of the semiconductor wafer 10 having the devices to be sealed. Then, attachment between the semiconductor wafer 10 and the glass substrate 11 is completed after passage of a predetermined time for curing. Note that a step of irradiating with ultraviolet ray the semiconductor wafer 10 and the glass substrate 11 is included in the procedure if the room temperature curable resin 12 is ultraviolet curable resin.

The described attachment procedure is performed at room temperature so that there occurs no expansion and shrinkage in the semiconductor wafer 10 and the glass substrate 11. This prevents generating of stresses at the boundary between the semiconductor wafer 10 and the glass substrate 11 after attachment is completed and thus prevents generating of cracks and so on due to rapid releasing of the stress when cutting.

Then, although not shown, the attached glass substrate 11 and semiconductor wafer 10 are cut along a scribe line of the semiconductor wafer 10 and divided into individual semiconductor packages. The stresses that has been generated in an attachment procedure using high temperature curable resin is not generated in each of these cut semiconductor packages. This is because the semiconductor wafer 10 and the glass substrate 11 are attached at room temperature and thus stress is not generated at the boundary there between before cutting. This can prevent the problem that an integrated circuit, its pad electrode, an organic film, microlens, and so on formed on the semiconductor substrate are damaged by wearing in a temperature cycle test.

In the above-described manufacturing method, a special glass material or a cutting blade of high quality, which has been required for preventing stress caused by temperature difference using high temperature curable resin, is not required, thereby reducing a manufacturing cost.

Although the room temperature curable resin 12 is ultraviolet curable resin or two-component epoxy resin in the above-described embodiment, the invention is not limited to this and the room temperature curable resin 12 can be curable resin having characteristics of curing at room temperature to attach the semiconductor wafer 10 and the glass substrate 11.

In the above-described embodiment, although the devices to be sealed formed on the semiconductor wafer 10 are sealed with the glass substrate 11, the invention is not limited to this and the devices to be sealed can be sealed by a substrate formed of a material which does not transmit light instead of the glass substrate when the devices to be sealed does not include a light-receiving element such as a CCD.

## Claims

1. A semiconductor device comprising:
- a semiconductor wafer (10) having a plurality of semiconductor integrated circuits (30);
- a supporting substrate (11) supporting the semiconductor wafer (10); and
- a layer of a room temperature curable resin (12) attaching the semiconductor wafer (10) to the supporting substrate (11).

2. The semiconductor device of claim 1, wherein there is no significant stress gradation across the layer of the room temperature curable resin (12).

3. The semiconductor device of claim 1 or 2, wherein the room temperature curable resin (12) is a resin that is cured upon application of ultraviolet ray.

4. The semiconductor device of claim 1 or 2, wherein the room temperature curable resin is a resin (12) that is cured upon mixing two different chemicals.

5. A method of manufacturing a semiconductor device, comprising:
- preparing a semiconductor wafer (10) having a plurality of semiconductor integrated circuits (30);
- preparing a supporting substrate (11);
- coating a room temperature curable resin (12) on a surface of the semiconductor wafer (10) or a surface of the supporting substrate (11);
- attaching at a room temperature the semiconductor wafer (10) to the supporting substrate (11) so that the room temperature curable resin (12) is placed between the semiconductor wafer (10) and the supporting substrate (11); and
- dividing the semiconductor wafer (10) attached to the supporting substrate (11) into individual semiconductor chips (30) by cutting the semiconductor wafer (10) along scribe lines (SL) thereof.

6. The method of claim 5, further comprising applying ultraviolet ray to the room temperature curable resin (12) placed between the semiconductor wafer (10) and the supporting substrate (11).

7. The method of claim 5, further comprising mixing two chemicals to produce the room temperature curable resin (12).
